# FASCICULE DE BREVET EUROPEEN

(11) **EP 1 771 055 B1**
(45) Date de publication et mention de la délivrance du brevet: **11.06.2008**
(21) Numéro de dépôt: 06121598.4
(22) Date de dépôt: 02.10.2006
(51) Int. Cl.: H05K 7/14

(54) **Dispositif d'amortissement pour une carte électronique coulissant dans des glissières**
Dampfungsvorrichtung für eine Leiterplatte, die auf Führungen gleitet
Electronic board damping device sliding in guides

(30) Priorité: 03.10.2005 FR 0510078
(43) Date de publication de la demande: 04.04.2007
(73) Titulaire: Thales, 92200 Neuilly Sur Seine (FR)
(72) Inventeur: Bonomi, Bénédicte, 92380, Garches (FR); Chapellier, Bertrand, 75010, Paris (FR)
(74) Mandataire: Lucas, Laurent Jacques

(56) Documents cités:
- EP-A- 0 014 391
- EP-A- 0 200 597
- EP-A- 1 033 909
- DE-A1- 3 310 109
- US-A1- 2004 196 639

## Description

La présente invention concerne un dispositif d'amortissement pour une carte électronique coulissant dans des glissières. Elle s'applique notamment dans tous les domaines où des assemblages électroniques complexes sont soumis à un environnement vibratoire contraignant, l'automobile et l'aéronautique par exemple.

De nombreux systèmes sont exposés à des contraintes sévères liées à leur environnement d'exploitation. Par exemple des assemblages électroniques peuvent être soumis à de fortes vibrations dans des systèmes installés sur des plate-formes mobiles ou même aéroportées. En effet le porteur du système, qu'il soit roulant ou volant, dispose non seulement d'équipements propulseurs continuellement générateurs de très fortes vibrations, mais la plate-forme elle-même est sujette à des mouvements générateurs de perturbations ponctuelles mais importantes. Les contraintes qui en découlent sont multiples.
Tout d'abord se pose le problème de résistance des matériaux employés. Dans ce domaine, un choix de composants et de procédés d'assemblage en respect de certaines normes strictes de tolérance aux vibrations permet d'atteindre un niveau de fiabilité satisfaisant quant à la résistance des matériaux.
Puis se pose le problème de fiabilité des dispositifs amovibles de connexion qui non seulement ne doivent pas se débrancher de manière inopportune sous l'effet des vibrations, mais qui doivent également faciliter des débranchements et des branchements aisés pendant les opérations de maintenance. Le raccordement d'une carte électronique dite « fille » à sa carte dite « mère » est un cas typique de cette problématique. On trouve généralement ces assemblages de plusieurs cartes filles à leur carte mère commune dans des coffrets dédiés, le coffret offrant une configuration compacte et modulaire tout à fait adaptée aux systèmes actuels. Mais dans ces coffrets la problématique d'usure précoce des connexions amovibles est accentuée par un phénomène dit de résonance des cartes. Ce phénomène est lié à la forme des cartes et à leur disposition dans le coffret où elles ne sont fixées que par leurs bords.

En effet, lorsqu'une carte électronique est soumise à des vibrations dans un coffret, celle-ci peut entrer dans un de ses modes de résonance selon les fréquences des vibrations qui l'excitent. Les vibrations que subit le coffret sont le résultat de la combinaison des mouvements vibratoires engendrés par plusieurs sources, les propulseurs et les perturbations liées au déplacement du porteur dans son environnement notamment. On qualifie d'ambiance vibratoire ce mélange de mouvements vibratoires. Dans un avion, ce sont les réacteurs et l'environnement aérodynamique qui génèrent l'ambiance vibratoire, sachant qu'en fonction de la zone de l'appareil dans laquelle se trouve le coffret, près des ailes ou près des réacteurs par exemple, le coffret sera soumis à un niveau de bruit spécifique. Dans une voiture c'est le moteur et les irrégularités de la route transmises par les roues qui génèrent le bruit vibratoire. Ainsi si le bruit est composé d'un mouvement vibratoire dont la fréquence correspond à un des modes de résonance de la carte, celle-ci se met à vibrer selon une certaine « déformée » c'est-à-dire en reproduisant une déformation caractéristique du mode de résonance excité. A une carte dans un coffret correspondent un mode de résonance du premier ordre avec la déformée et la fréquence associées, un mode de résonance du second ordre avec la déformée et la fréquence associées, et ainsi de suite, les fréquences étant croissantes avec l'ordre du mode. Une carte ne vibre pas à d'autres fréquences qu'à celles de ses modes de résonance, mais lorsque qu'une carte entre dans un de ses modes de résonance, alors cela s'accompagne également d'un phénomène d'amplification de l'amplitude des vibrations. Les valeurs d'amplification dépendent du mode, sachant que plus le mode est bas en fréquence plus l'amplification crée du déplacement. Notamment au premier mode, les valeurs d'amplification peuvent créer des déformations très importantes et amener au débranchement inopiné, à l'usure prématurée, voire même à la destruction des connecteurs de la carte.
Une solution actuelle à ce problème de résonance des cartes est d'utiliser des connecteurs qualifiés pour les normes les plus strictes (spécifiques) de tolérance aux vibrations ou de développer des connecteurs spécifiques. Plus chère, cette solution ne fait souvent que décaler dans le temps le changement des connecteurs, qui finissent quand même par s'user.

Une autre solution est d'empêcher la carte de vibrer sous l'effet du bruit ou tout au moins de limiter ses vibrations. Il s'agit de rigidifier la carte en lui ajoutant une structure rigide appelée raidisseur. Par exemple ce peut être une barre métallique transversale fixée rigidement sur la carte. Plus efficace, cette solution a cependant l'inconvénient majeur de limiter l'implantation des composants sur la carte. En effet à l'emplacement d'un raidisseur aucun composant ne peut être positionné et soudé.
Une façon connue d'empêcher les cartes de vibrer dans le cas où plusieurs cartes sont mitoyennes, ce qui est maintenant souvent le cas des assemblages électroniques au vu des exigences de compacité des systèmes actuels, notamment dans un coffret, c'est aussi de déposer du gel amortissant directement entre les cartes. Cette solution ne facilite cependant pas la maintenance, tout spécialement des composants implantés sous le gel amortissant. En effet, selon le gel utilisé leur maintenance peut revenir chère ou même être impossible, en raison de l'arrachement de composants lorsqu'on retire le gel par exemple.
Enfin certaines solutions attaquent le problème beaucoup plus en amont du phénomène de propagation des vibrations puisqu'elles consistent soit à isoler l'ensemble du système des vibrations de la plate-forme porteuse, soit même à annuler le bruit de la plate-forme porteuse. Dans le cas des solutions d'isolation de l'ensemble du système, il s'agit de suspendre les cartes dans le coffret qui les contient ou de suspendre le coffret contenant le système par l'intermédiaire d'un matériau amortissant, des « silentblocs »par exemple. Dans le cas des solutions d'annulation du bruit, il s'agit de générer volontairement des vibrations aux mêmes fréquences que celles de l'excitation mais en inversant le signal (opposition de phase) qui vont empêcher la carte d'entrer dans un de ses modes de résonance. Ces solutions d'annulation du bruit où des vibrations supplémentaires sont volontairement générées sont dites solutions actives par opposition aux autres solutions dites passives où l'on ne génère pas de vibrations, comme celles décrites précédemment. Les solutions d'isolation de l'ensemble du système et d'annulation du bruit ont pour principal inconvénient qu'elles modifient soit la configuration du coffret, soit l'interface avec le porteur et qu'elles nécessitent plus de place dans le porteur. Ainsi ces solutions peuvent avoir un impact sur des systèmes tiers embarqués sur le porteur.

Les documents EP-A-1 033 909, DE 33 10 109 A1, EP-A-0 200 597, US 2004/196639 A1, EP-A-0 014 391 sont des exemples de l'art antérieur de dispositifs raidisseurs, amortisseurs de vibrations.

L'invention a notamment pour but de pallier les inconvénients précités en absorbant efficacement les vibrations d'une carte coulissant dans des glissières. A cet effet, l'invention a pour objet un dispositif d'amortissement pour une carte électronique coulissant dans des glissières. Ce dispositif comporte au moins une paire de cales formant chacune une concavité, cette concavité étant garnie d'une pièce d'un matériau amortisseur. Chaque paire de cales est disposée autour de la carte au niveau d'évidements des bords de la carte qui coulissent dans les glissières en mettant en regard les concavités des cales. Les bords des cales en contact au niveau des évidements de la carte coulissent solidairement dans les glissières.
Les pièces de matériau amortisseur peuvent par exemple être des matériaux amortisseur standard à base d'élastomère et les cales peuvent par exemple être métalliques.

L'invention a encore pour principaux avantages qu'elle s'adapte à la majorité des implantations de composants sur les cartes par simple coulissement des cales. La majorité des composants pouvant tenir sous les cales, elle permet également de contrer les modes de résonance les plus endommageants. Elle facilite également la maintenance puisque la dépose de la carte amortie implique également la dépose des cales sans aucune opération supplémentaire et donc l'accès facile aux composants couverts par les cales.
Notamment dans le cadre d'un coffret à glissières, l'invention a encore pour principaux avantages qu'elle ne modifie pas l'interface avec la plate-forme porteuse du coffret, qu'elle s'applique à toutes les configurations intérieures de coffret à glissières sans aucune modification. Elle permet de plus d'amortir chaque carte dans le coffret de manière autonome et ciblée, c'est-à-dire en privilégiant un mode de résonance propre à chaque cale, sans aucun impact sur les cartes voisines. Il est à noter aussi que les cales sont réutilisables sur des coffrets et des cartes de même taille. Dans un contexte industriel de fabrication en grande série de coffrets standardisés, ces nombreux avantages se traduisent par une baisse des coûts de production.

D'autres caractéristiques et avantages de l'invention apparaîtront à l'aide de la description qui suit faite en regard de dessins annexés qui représentent :
- la figure 1, une illustration d'un exemple de réalisation d'un dispositif selon l'invention par une vue de dessus;
- les figures 2a, 2b et 2c, par des schémas les déformations caractéristiques d'une carte vibrant selon ses modes de résonance du premier, du deuxième et du troisième ordre ;
- la figure 3, une illustration de l'exemple de réalisation précédent d'un dispositif selon l'invention par une vue en coupe transversale ;
- les figures 4a et 4b, une illustration de l'exemple de réalisation précédent d'un dispositif selon l'invention par une vue en perspective.

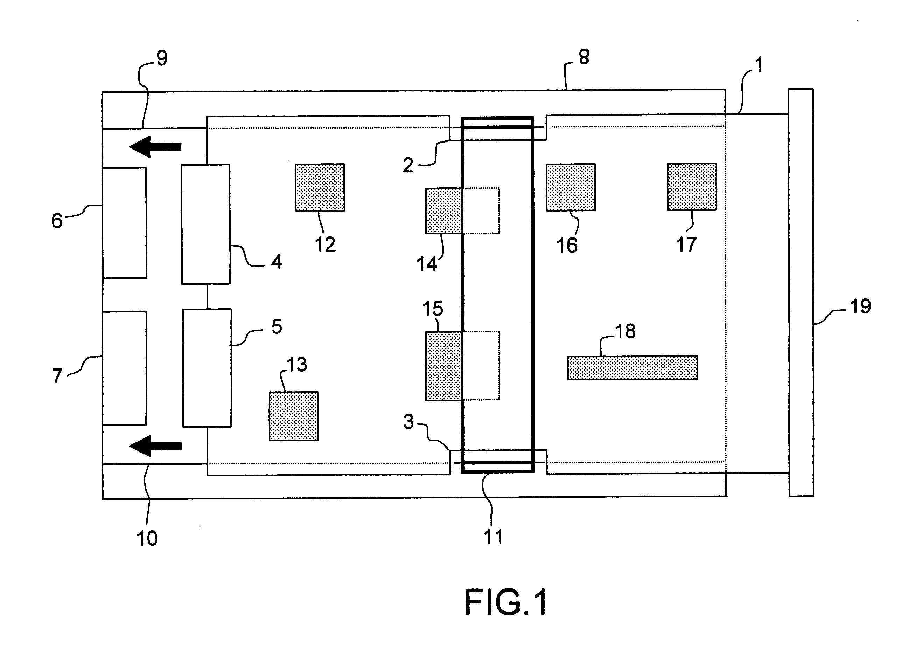

La figure 1 illustre par une vue en coupe latérale un exemple de réalisation du dispositif selon l'invention. Il comporte une carte électronique 1 à amortir et sur laquelle sont par exemple assemblés divers composants 12, 13, 14, 15, 16, 17 et 18. La carte coulisse par exemple dans un coffret 8 le long de glissières 9 et 10 creusées dans des parois opposées à l'intérieur du coffret. Dans ce mode de réalisation des connecteurs enfichables 4 et 5 disposés sur le bord de la carte dirigé vers le fond du coffret s'enfichent dans des connecteurs 6 et 7 disposés au fond du coffret. Ces connecteurs de fond de coffret peuvent par exemple être les connecteurs permettant de brancher la carte fille à sa carte mère qui serait disposée transversalement au fond du coffret. Dans ce mode de réalisation la carte est rigidement fixée au coffret lorsqu'elle arrive en fond de glissière grâce à un bandeau de fixation 19 muni de vis ou d'un dispositif de fixation quelconque. La carte comporte par exemple deux évidements 2 et 3 creusés symétriquement au milieu des bords coulissant dans les glissières et une paire de cales 11 et 20 est disposée transversalement de part et d'autre de la carte au niveau des évidements, la cale 20 étant masquée par la cale 11 sur la figure. Avantageusement les cales peuvent être usinées sous la forme de bandes métalliques rigides. En tous cas, elles ne doivent pas dépasser au-delà des bords de la carte. La longueur des cales est donc sensiblement la largeur de la carte et la largeur des cales est par exemple de l'ordre d'un cinquième à un dixième de la longueur de la carte. La taille des évidements aux bords de la carte permet au moins aux deux cales de s'appuyer librement l'une sur l'autre au niveau des évidements.

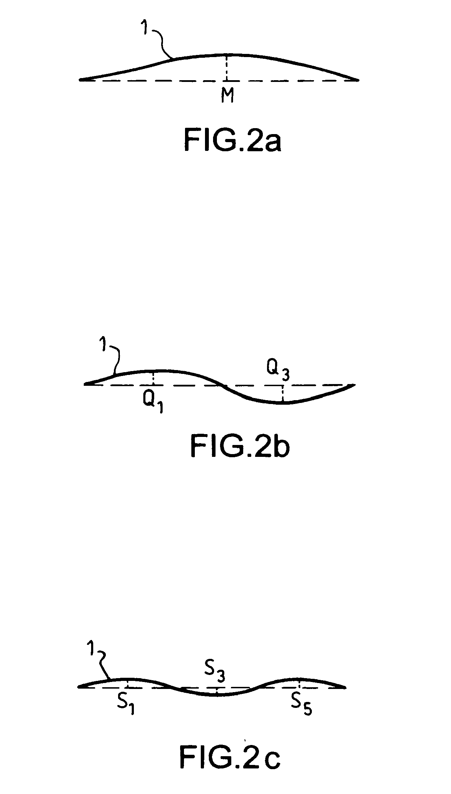

La figure 2a illustre la déformation caractéristique de la carte 1 par une vue de profil et vibrant selon son premier mode de résonance. Disposer une cale transversalement sensiblement au milieu M de la carte permet de concentrer l'effort d'amortissement là où la déformée du premier ordre a la plus forte amplitude, c'est-à-dire là où la carte se déforme le plus. S'agissant du mode de résonance du 1^{er} ordre, c'est celui qu'il faut amortir en priorité, sachant que les modes suivants seront également amortis par ce dispositif même si ce n'est pas de manière optimale. Plus d'une paire de cales peuvent être disposées le long de la carte à condition que les évidements correspondants aient été creusés de manière appropriée en des emplacements symétriques le long des bords coulissant dans les glissières du coffret. Comme le montre la figure 2b, qui illustre la déformation caractéristique de la carte 1 vue de profil et vibrant selon son second mode de résonance, la disposition optimale des cales pour amortir le mode de résonance du second ordre sera de disposer des cales sensiblement aux quarts Q1 et Q3 de la longueur de la carte, là où l'amplitude de déformation est maximale. De même et comme le montre la figure 2c, qui illustre la déformation caractéristique de la carte 1 vue de profil et vibrant selon son troisième mode de résonance, la disposition optimale des cales pour amortir le mode de résonance du troisième ordre sera de disposer des cales sensiblement aux sixièmes S1, S3 et S5 de la longueur de la carte. Ainsi quel que soit le mode de résonance visé, même au-delà du troisième ordre, des paires de cales identiques peuvent être disposées symétriquement de part et d'autre des faces de la carte pour optimiser l'amortissement. Dans le mode de réalisation illustré par la figure1 où l'effort d'amortissement est concentré sur le premier mode de résonance, il y a donc une cale de chaque côté de la carte sensiblement en son milieu. Cette configuration représente un optimum entre masse et efficacité de l'amortissement, entraînant notamment une réduction du 1^{er} mode de résonance donc des usures.

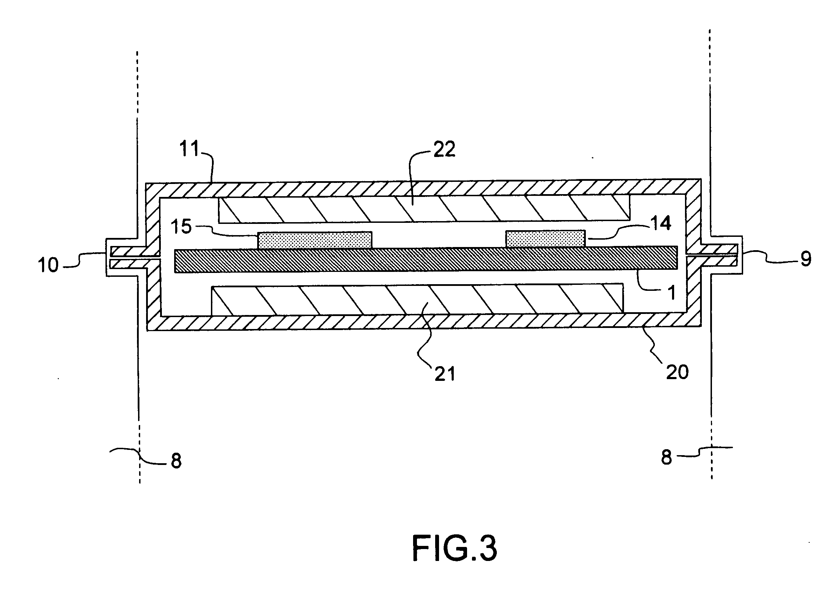

La figure 3 illustre par une vue en coupe transversale l'exemple de réalisation précédent d'un dispositif selon l'invention. La coupe est réalisée au niveau des évidements 2 et 3 de la carte 1 et au niveau de la cale 11, ce qui explique que ce n'est pas la carte qui est insérée dans les glissières 9 et 10 à cet endroit mais les cales. En dehors des évidements, c'est bien la carte qui est insérée dans les glissières. La cale 11 et la cale 20 sont disposées de part et d'autre des faces de la carte au niveau des évidements de manière symétrique. L'épaisseur des cales, au moins au niveau de ses bords, est un peu moins de la moitié de la largeur des glissières du coffret qui est aussi l'épaisseur de la carte, composants et connecteurs compris, ainsi les bords des cales en contact coulissent sans jeu dans les glissières du coffret. Les cales sont réalisées de manière à laisser un espace avec les composants assemblés sur la carte. Par souci de simplification, seuls les composants 14 et 15 ont été représentés sur cette figure. Des pièces 21 et 22 d'un matériau amortisseur sont collés côté cales et se trouvent interposées entre les cales et les composants assemblés sur la carte. Ce sont ces pièces amortissantes qui vont limiter les vibrations de la carte.

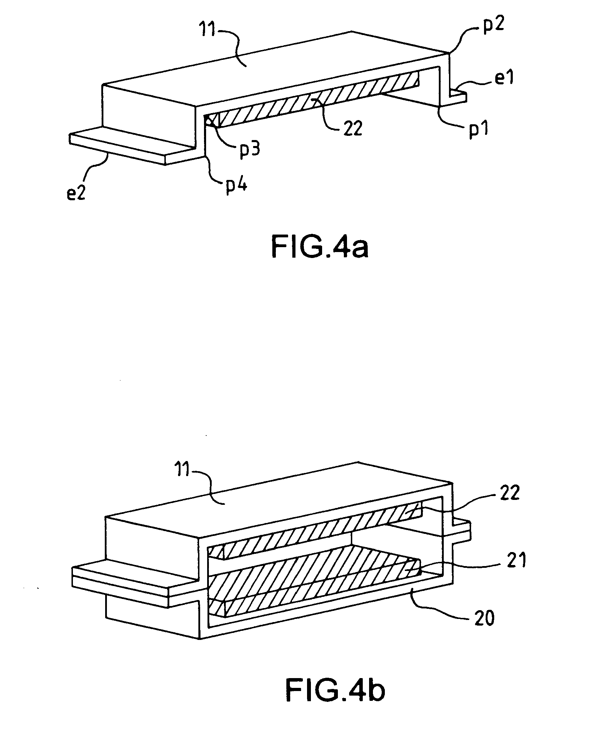

La figure 4a illustre l'exemple de réalisation précédent d'un dispositif selon l'invention par une vue en perspective de la cale 11 garnie de la pièce de matériau amortisseur 22. La cale est usinée en forme de bande pliée transversalement en quatre emplacements successifs p1, p2, p3 et p4 de sa longueur entre ses deux extrémités e1 et e2. Les plis sont réalisés de manière à inscrire les deux bords de la cale, c'est-à-dire les parties entre e1 et p1 et entre p4 et e2, dans un même plan et à les orienter dans des directions opposées l'un de l'autre, et de manière à inscrire la partie centrale de la cale entre les plis p2 et p3 dans un plan parallèle au plan commun des bords pour former une concavité. Ainsi la cale forme une concavité entre p2 et p3 destinée à accueillir parallèlement la carte à amortir et ses bords entre e1 et p1 et entre p4 et e2 peuvent être introduits dans les glissières qui se font face de part et d'autre des parois du coffret. Dans le mode de réalisation illustré par la figure, les plis sont réalisés symétriquement de part et d'autre de l'axe médian transversal de la cale et selon un même angle droit. Mais on peut envisager d'autres emplacements non symétriques des plis le long de la cale selon plusieurs valeurs d'angles plus ou moins ouverts. La seule contrainte est que ces emplacements non symétriques et ces valeurs d'angles doivent être compatibles des évidements de la carte, c'est-à-dire que la carte doit pouvoir être accueillie parallèlement à la cale dans la concavité. Cette concavité de la cale entre les plis p2 et p3 accueille la pièce de matériau amortisseur puisqu'elle est destinée à être en regard de la carte à amortir.

La figure 4b illustre l'exemple de réalisation précédent d'un dispositif selon l'invention par une vue en perspective de la cale 11 garnie de la pièce de matériau amortisseur 22 et de la cale 20 garnie de la pièce de matériau amortisseur 21, les cales étant agencées selon l'invention, c'est-à-dire de manière à mettre leurs concavités en regard l'une de l'autre. Les deux cales sont en contact au niveau de leurs bords uniquement, à savoir les parties entre e1 et p1 et entre p4 et e2. Dans le mode de réalisation illustré par la figure, les deux cales sont strictement identiques, mais on peut envisager un dispositif selon l'invention avec des cales différentes. La carte à amortir est disposée dans l'espace laissé libre entre les pièces de matériau amortisseur 21 et 22, à hauteur de ses évidements, la carte étant en contact plus ou moins appuyé sur les parties amortissantes avec ces pièces selon l'épaisseur des composants assemblés. Avantageusement et pour profiter des techniques les plus récentes d'amortissement, les pièces de matériau amortissant peuvent être simplement des pièces en élastomère simple, ces pièces devant être collées aux cales. Avec un matériau amortisseur standard du commerce, dans le mode de réalisation à une seule paire de cales centrale permettant de privilégier l'amortissement du premier mode de résonance et pour certains niveaux d'excitation du coffret correspondant à l'ambiance vibratoire sévère de certaines plate-formes aéroportées, l'amplification au centre de la carte passe d'un facteur 140 à un facteur 25, soit une atténuation de l'ordre de 8 décibels. Cette atténuation peut même atteindre 15 décibels pour des excitations de plus faible amplitude. Ces résultats sont bien meilleurs que ceux que l'on peut obtenir avec les anciennes solutions, ce qui montre l'efficacité du dispositif selon l'invention.
Il est à noter que la grande majorité des composants électroniques s'insèrent aisément entre la carte et les parties amortissantes même si ce sont eux qui subissent le contact le plus appuyé. C'est un des avantages essentiels de la solution, sachant que la disposition des composants sur la carte dépend de contraintes physiques peu flexibles liées à la dissipation de la chaleur à la surface de la carte ou à la répartition des masses ou encore des contraintes liées au manque de déformabilité de certains matériaux comme la céramique. La majorité de ces composants peut supporter l'appui des parties amortissantes sans problème associé. Enfin, la possibilité de positionner les cales n'importe où le long de la carte permet non seulement des positionnements optimaux visant certains modes de résonance, au milieu M comme dans l'exemple de réalisation ou aux quarts Q1 et Q3 ou encore aux sixièmes S1, S3 et S5, et ainsi de suite, mais cela permet également de s'adapter à tous les cas particuliers d'implantation sur la carte de composants de forme vraiment atypique, notamment en hauteur, qui ne permettent pas un positionnement optimal des cales le long de la carte. C'est un avantage essentiel de l'invention.
Avantageusement, l'invention permet d'obtenir un dispositif de coffret à glissières pour cartes électroniques, facilement démontable et n'ayant pas besoin de système de fixation particulier. Il peut, par exemple, s'installer et s'enlever sur du matériel existant, pourvu que la carte électronique ait les évidements nécessaires à l'installation des cales.

## Revendications

1. Dispositif d'amortissement pour une carte électronique coulissant dans des glissières, **caractérisé en ce qu'**il comporte au moins une paire de cales (11, 20) formant chacune une concavité, cette concavité étant garnie d'une pièce d'un matériau amortisseur (21, 22), chaque paire de cales étant disposée autour de la carte au niveau d'évidements des bords de la carte qui coulissent dans les glissières en mettant en regard les concavités des cales, les bords des cales en contact au niveau des évidements de la carte coulissant solidairement dans les glissières.

2. Dispositif d'amortissement pour une carte électronique coulissant dans des glissières selon la revendication 1, **caractérisé en ce que** les pièces de matériau amortisseur (21, 22) sont des amortisseurs à base d'élastomère.

3. Dispositif d'amortissement pour une carte électronique coulissant dans des glissières selon l'une quelconque des revendications précédentes, **caractérisé en ce que** les cales (11, 20) sont métalliques.

4. Dispositif de coffret à glissières pour cartes électroniques, **caractérisé en ce qu'**il comporte au moins :
- une carte coulissant dans les glissières du coffret et comportant des évidements sur ses bords coulissant ;
- une paire de cales (11, 20) formant chacune une concavité, cette concavité étant garnie d'une pièce d'un matériau amortisseur (21, 22) ;
la paire de cales étant disposée autour de la carte au niveau de ses évidements en mettant en regard les concavités des cales, les bords des cales en contact au niveau des évidements de la carte coulissant solidairement dans les glissières.

5. Dispositif de coffret à glissières pour cartes électroniques selon la revendication 4, **caractérisé en ce que** les pièces de matériau amortisseur (21, 22) sont en élastomère simple.

6. Dispositif de coffret à glissières pour cartes électroniques selon l'une quelconque des revendications 4 ou 5, **caractérisé en ce que** les cales (11, 20) sont métalliques.

## Claims

1. Cushioning device for an electronic card sliding in slideways, **characterized in that** it comprises at least one pair of blocks (11, 20) each forming a concavity, this concavity being lined with a piece of a cushioning material (21, 22), each pair of blocks being positioned around the card in line with cut-outs in the edges of the card which slide in the slideways by positioning the concavities of the blocks facing each other, the edges of the blocks in contact in line with the cut-outs of the card sliding jointly in the slideways.

2. Cushioning device for an electronic card sliding in slideways according to Claim 1, **characterized in that** the pieces of cushioning material (21, 22) are elastomer-based cushions.

3. Cushioning device for an electronic card sliding in slideways according to any one of the preceding claims, **characterized in that** the blocks (11, 20) are metallic.

4. Box device with slideways for electronic cards, **characterized in that** it comprises at least:
- a card sliding in the slideways of the box and including cut-outs on its sliding edges; and
- a pair of blocks (11, 20), each forming a concavity, this concavity being lined with a piece of a cushioning material (21, 22);
the pair of blocks being positioned around the card in line with its cut-outs by placing the concavities of the blocks facing one another, the edges of the blocks in contact in line with the cut-outs of the card sliding jointly in the slideways.

5. Box device with slideways for electronic cards according to Claim 4, **characterized in that** the pieces of cushioning material (21, 22) are made of simple elastomer.

6. Box device with slideways for electronic cards according to either of Claims 4 or 5, **characterized in that** the blocks (11, 20) are metallic.

## Patentansprüche

1. Dämpfungsvorrichtung für eine in Gleitschienen gleitende elektronische Karte, **dadurch gekennzeichnet, dass** sie wenigstens ein Paar von Passstücken (11, 20) enthält, die jeweils eine Konkavität bilden, wobei diese Konkavität mit einem Teil (21, 22) aus einem Dämpfungsmaterial ausgekleidet ist, wobei jedes Paar von Passstücken um die Karte auf Höhe von Aussparungen in den Kanten der Karte, die in den Gleitschienen gleiten, angeordnet ist, indem die Konkavitäten der Passstücke einander gegenüber angeordnet sind, wobei die Kanten der Passstücke, die auf Höhe der Aussparungen der Karte miteinander in Kontakt sind, fest verbunden in den Gleitschienen gleiten.

2. Dämpfungsvorrichtung für eine in Gleitschienen gleitende elektronische Karte nach Anspruch 1, **dadurch gekennzeichnet, dass** die Teile (21, 22) aus Dämpfungsmaterial Dämpfer auf Elastomerbasis sind.

3. Dämpfungsvorrichtung für eine in Gleitschienen gleitende elektronische Karte nach einem der vorhergehenden Ansprüche, **dadurch gekennzeichnet, dass** die Passstücke (11, 20) aus Metall sind.

4. Schrankvorrichtung mit Gleitschienen für elektronische Karten, **dadurch gekennzeichnet, dass** sie wenigstens enthält:
- eine Karte, die in den Gleitschienen des Schranks gleitet und an ihren Gleitkanten Aussparungen aufweist;
- ein Paar von Passstücken (11, 20), die jeweils eine Konkavität bilden, wobei diese Konkavität mit einem Teil (21, 22) aus Dämpfungsmaterial ausgekleidet ist;
wobei das Paar von Passstücken um die Karte auf Höhe ihrer Aussparungen angeordnet ist, indem die Konkavitäten der Passstücke einander gegenüber angeordnet sind, wobei die Ränder der Passstücke, die auf Höhe der Aussparungen der Karte miteinander in Kontakt sind, fest verbunden in den Gleitschienen gleiten.

5. Schrankvorrichtung mit Gleitschienen für elektronische Karten nach Anspruch 4, **dadurch gekennzeichnet, dass** die Teile (21, 22) aus Dämpfungsmaterial aus einem einfachen Elastomer sind.

6. Schrankvorrichtung mit Gleitschienen für elektronische Karten nach einem der Ansprüche 4 oder 5, **dadurch gekennzeichnet, dass** die Passstücke (11, 20) aus Metall sind.
